(19) Europäisches Patentamt / European Patent Office / Office européen des brevets

(11) EP 2 940 699 B1

(12) EUROPEAN PATENT SPECIFICATION

(45) Date of publication and mention
of the grant of the patent:
**05.12.2018 Bulletin 2018/49**

(51) Int Cl.:
*H01L 39/14* (2006.01)  *H01B 12/06* (2006.01)
*H01F 6/06* (2006.01)

(21) Application number: **13868560.7**

(22) Date of filing: **26.12.2013**

(86) International application number:
**PCT/JP2013/084934**

(87) International publication number:
**WO 2014/104208 (03.07.2014 Gazette 2014/27)**

(54) **OXIDE SUPERCONDUCTOR WIRE**

OXYDSUPRALEITERDRAHT

FIL SUPRACONDUCTEUR EN OXYDE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **28.12.2012 JP 2012288302**

(43) Date of publication of application:
**04.11.2015 Bulletin 2015/45**

(73) Proprietor: **Fujikura Ltd.**
**Tokyo 135-8512 (JP)**

(72) Inventors:
• **TAKEMOTO Tetsuo**
**Sakura-shi**
**Chiba 285-8550 (JP)**
• **HIDAKA Hikaru**
**Sakura-shi**
**Chiba 285-8550 (JP)**

(74) Representative: **Cabinet Plasseraud**
**66, rue de la Chaussée d'Antin**
**75440 Paris Cedex 09 (FR)**

(56) References cited:
**WO-A1-2012/039444    JP-A- 2009 022 118
JP-A- 2010 207 059    JP-A- 2012 109 254
JP-A- 2012 150 914    JP-A- 2012 169 237
US-A1- 2006 073 975    US-A1- 2008 194 411
US-A1- 2009 110 906**

## Description

### TECHNICAL FIELD

The present invention relates to an oxide superconductor wire used for superconductor equipment such as a superconductor current-limiting device.

### BACKGROUND ART

Electric equipment capable of solving the recent energy challenges includes superconductor equipment such as cable, coil, motor, magnet, and superconductor current-limiting device with the use of an oxide superconductor which is a low-loss electrically conductive material. As a superconductor used for the superconductor equipment, an oxide superconductor such as an RE-123-based oxide superconductor ($REBa_2Cu_3O_{7-x}$: RE being a rare-earth element containing Y, Gd etc.) is known. The oxide superconductor exhibits superconductive properties at around the liquid nitrogen temperatures and is capable of maintaining a relatively high critical current density even in a strong magnetic field, and therefore is regarded as an extremely promising electrically conductive material in practice.

When applying the above-described oxide superconductor to electric equipment, the oxide superconductor is processed to form a wire in general. For example, Patent Document 1 discloses an oxide superconductor wire using a laminate which includes an oxide superconductor layer formed on a tape-shaped metal substrate via an interlayer having good crystal orientation and a protection layer formed so as to cover the oxide superconductor layer. The outer periphery of the laminate is provided with a stabilization layer formed by covering the outer periphery with a wide-width metal tape via a solder layer. Since the protection layer and the stabilization layer of such an oxide superconductor wire serve to bypass overcurrent in case of emergency, they are formed of low electrical resistance materials. For example, the protection layer may be formed of Ag or an Ag alloy and the stabilization layer may be formed of Cu.

When applying the oxide superconductor wire to superconductor current-limiting devices, in order to increase the electrical resistance in its normal conducting state, it is required to form high electrical resistance materials, as a high-resistance layer, on the oxide superconductor layer. For example, Patent Document 2 describes the use of metals, as the high-resistance layer formed on the substrate or the oxide superconductor layer, of which the electrical resistivity is no less than $1\times10^{-7}$ $\Omega\cdot m$ and no more than $1\times10^{-5}$ $\Omega\cdot m$ at room temperature. Patent Document 3 discloses a cryogenically-cooled HTS wire configured to operate as fault current limiting device, comprising a stabilizer and a substrate layer. Patent Document 4 is related to an elongated article comprising a first and second layer of oxide superconductor filaments, and a barrier layer. Patent Document 5 is related to an oxide superconducting wire material compounding a high-resistance material, and to a production method of the same. Patent Document 6 relates to a bubble-freely bonding adhesive layer with an adhesive and with a channel element, to the use of the adhesive layer to produce a bubble-free bond, to the use of the adhesive layer to produce a bubble-freely bonding sheetlike structure and to a method of producing such structure.

### PRIOR ART DOCUMENTS

### PATENT DOCUMENTS

[Patent Document 1] Japanese Unexamined Patent Application, First Publication No. 2012-169237
[Patent Document 2] Japanese Unexamined Patent Application, First Publication No. 2007-227167
[Patent Document 3] US Patent Application, No. 2008-194411
[Patent Document 4] US Patent Application, No. 2006-073975
[Patent Document 5] Japanese Patent Application, No. 2012-150914
[Patent Document 6] US Patent Application, No. 2009-110906

### DISCLOSURE OF INVENTION

### PROBLEMS TO BE SOLVED BY THE INVENTION

When applying the configuration described in Patent Document 1, in which the protection layer and the stabilization layer are formed on the oxide superconductor layer, to the oxide superconductor wire for superconductor current-limiting devices, the combined resistance of the protection layer and the stabilization layer is required to be within the resistance value described in Patent Document 2.

Since Ag is a costly material, there is a demand for further reducing the thickness of the protection layer which contains Ag. The protection layer is formed of Ag or an Ag alloy and exhibits significantly lower volume resistivity compared to the stabilization layer. As the thickness of the protection layer is reduced, the thickness of the stabilization layer needs to be considerably thicker to compensate that, which will enlarge the thickness of the oxide superconductor wire. If the thickness of the oxide superconductor wire is enlarged, it will be impossible to increase the magnetic field density of the coil formed by winding the oxide superconductor wire.

The present invention was made in view of the above-described circumstances and the object thereof is providing an oxide superconductor wire for use in superconductor current-limiting devices, which is, even if the thickness of the protection layer is reduced, capable of preventing burnout, exhibiting stable current limiting characteristics, and limiting the enlargement of the thickness of the oxide superconductor wire.

## MEANS FOR SOLVING THE PROBLEMS

The current invention defines an invention according to the independent device claim 1.

Since the thickness of the protection layer formed of Ag or an Ag alloy is 5 $\mu$m or less, it is possible to reduce the amount of Ag used for the oxide superconductor wire, and thereby reduce the cost. In addition, since the volume resistivity of the metal tape at room temperature is no less than 3.8 $\mu\Omega\cdot$cm and no more than 15 $\mu\Omega\cdot$cm, it is possible, even when electric current 1.5-3 times the critical current is applied, to limit the excessive current and thereby prevent burnout of the oxide superconductor wire and achieve stable current limiting characteristics in superconductor current-limiting devices using the oxide superconductor wire even with the thickness of the protection layer of 5 $\mu$m or less.

Additionally, an oxide superconductor wire includes: a tape-shaped substrate, an interlayer laminated on the substrate, an oxide superconductor layer laminated on the interlayer, and a protection layer which is formed of Ag or an Ag alloy and laminated on the oxide superconductor layer; and a stabilization layer which is formed of a metal tape and formed on the protection layer of the superconductor laminate via a low melting point metal layer, wherein the thickness of the protection layer is 5 $\mu$m or less, and wherein a resistance value of the oxide superconductor wire per 1 cm width and 1 cm length at room temperature is no less than 150 $\mu\Omega$ and no more than 100 m$\Omega$.

Since the thickness of the protection layer formed of Ag or an Ag alloy is 5 $\mu$m or less, it is possible to reduce the amount of Ag used for the oxide superconductor wire, and thereby to reduce the cost. In addition, since the resistance value of the oxide superconductor wire per 1 cm width and 1 cm length at room temperature is no less than 150 $\mu\Omega$ and no more than 100 m$\Omega$, it is possible, even when electric current 1.5-3 times the critical current is applied, to limit the excessive current and thereby prevent the burnout of the oxide superconductor wire and achieve stable current limiting characteristics in superconductor current-limiting devices using the oxide superconductor wire even with the thickness of the protection layer of 5 $\mu$m or less.

It may be arranged such that a width of the metal tape constituting the stabilization layer is greater than the width of the oxide superconductor laminate, and a top face of the protection layer of the oxide superconductor laminate, side faces of the protection layer, the oxide superconductor layer, the interlayer and the substrate, and at least a part of a back face of the substrate are covered with the stabilization layer via the low melting point metal layer.

In this case, since the outer periphery of the oxide superconductor laminate is covered with the metal tape, it possible to prevent the oxide superconductor layer from deteriorating due to intrusion of moisture.

It may be arranged such that the thickness of the stabilization layer is no less than 9 $\mu$m and no more than 60 $\mu$m.

In this case, the thickness of the stabilization layer is no less than 9 $\mu$m and no more than 60 $\mu$m. More specifically, the thickness of the metal tape covering the oxide superconductor laminate is no less than 9 $\mu$m and no more than 60 $\mu$m. With the metal tape having a thickness of no less than 9 $\mu$m, it is possible to prevent the metal tape from tearing in the process of covering the oxide superconductor laminate with the metal tape. Moreover, the metal tape having a thickness of 60 $\mu$m or less will facilitate the forming of the metal tape and reliably cover the oxide superconductor laminate.

A superconductor coil includes the oxide superconductor wire described above.

A superconductor current-limiting device includes the oxide superconductor wire described above.

A superconductor equipment includes the oxide superconductor wire described above.

With the use of the oxide superconductor wire in superconductor coils, superconductor current-limiting devices, and the other superconductor equipment, it is possible to enhance the protection performance of the superconductor equipment with respect to moisture. In addition, it is possible to prevent the burnout of the oxide superconductor wire when excessive current flows in the oxide superconductor wire. Accordingly, it is possible to achieve more reliable superconductor equipment compared to the conventional one.

## EFFECTS OF THE INVENTION

According to the above-described aspect of the present invention, since the thickness of the protection layer formed of Ag or an Ag alloy is 5 $\mu$m or less, it is possible to reduce the amount of Ag used for the oxide superconductor wire, and thereby reduce the cost. In addition, since the volume resistivity of the metal tape at room temperature is no less than 3.8 $\mu\Omega\cdot$cm and no more than 15 $\mu\Omega\cdot$cm, it is possible, even when electric current 1.5-3 times the critical current is applied, to limit the excessive current, and thereby prevent burnout of the oxide superconductor wire and achieve stable current limiting characteristics in superconductor current-limiting devices using the oxide superconductor wire even with the thickness of the protection layer of 5 $\mu$m or less.

BRIEF DESCRIPTION OF THE DRAWINGS

FIG. 1 is a perspective view showing a lateral cross section of the oxide superconductor wire.

FIG. 2 is a perspective view showing a partial cross section of an example of the oxide superconductor laminate arranged in the oxide superconductor wire shown in FIG. 1.

FIG. 3A is a cross-sectional view showing a state where the metal tape is arranged under the oxide superconductor laminate in an example of a manufacturing method of the oxide superconductor wire shown in FIG. 1.

FIG. 3B is a cross-sectional view showing a state where the metal tape arranged under the oxide superconductor laminate is bent in an example of a manufacturing method of the oxide superconductor wire shown in FIG. 1.

FIG. 3C is a cross-sectional view showing a state where the metal tape is soldered to the oxide superconductor laminate in an example of a manufacturing method of the oxide superconductor wire shown in FIG. 1.

FIG. 4 is a lateral cross-sectional view showing a modified example of the oxide superconductor wire.

FIG. 5 is a lateral cross-sectional view showing a modified example of the oxide superconductor wire.

FIG. 6 is a cross-sectional view showing an example of a superconductor current-limiting device.

FIG. 7A is a perspective view showing a laminate of a superconductor coil.

FIG. 7B is a perspective view showing a superconductor coil.

FIG. 8 is a graph showing the suppression of fault current obtained by the oxide superconductor wire.

EXAMLES FOR CARRYING OUT THE INVENTION

Hereinafter, oxide superconductor wires according to examples of the present invention will be described with reference to the drawings. It should be noted that, in the drawings, some parts are magnified in shape for the purpose of explanation, but the proportions, for example, of the components shown in the drawings are not necessarily the same as the actual ones.

(Oxide superconductor wire)

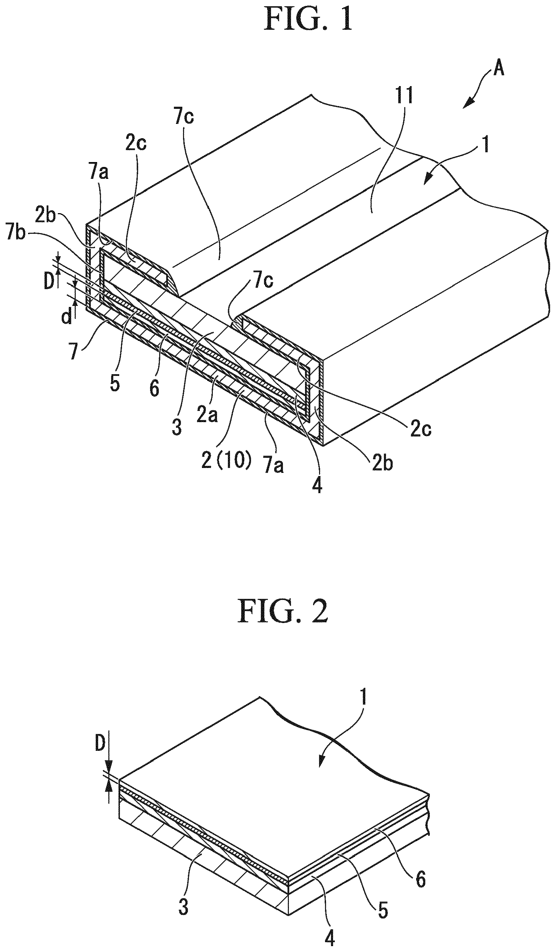

FIG. 1 is a perspective view showing a lateral cross section of the oxide superconductor wire according to the present invention. An oxide superconductor wire A according to the example includes a tape-shaped oxide superconductor laminate 1 and a metal tape 2 formed of an electrically conductive material such as a copper and covering the oxide superconductor laminate 1.

The oxide superconductor laminate 1 includes a tape-shaped substrate 3, an interlayer 4, an oxide superconductor layer 5, and a protection layer 6 as shown in FIG. 2. The interlayer 4, the oxide superconductor layer 5, and the protection layer 6 are laminated onto the substrate 3 in this order.

Hereinafter, each component of the oxide superconductor laminate 1 will be described in detail based on FIG. 2.

The substrate 3 may be one which is capable of being used for a substrate of common oxide superconductor wires and preferably has flexibility and elongated tape shape. In addition, the material of the substrate 3 preferably contains a metal which has high mechanical strength and heat resistance and can be easily processed into wires. Examples of such materials includes, for example, various kinds of heat-resistance metal materials including a nickel alloy such as stainless steel and HASTELLOY, and materials having ceramics arranged on the various kinds of metal materials. In particular, HASTELLOY (Trade name, HAYNES INT. INC., USA) is preferable among commercially available products. Various kinds of HASTELLOY such as HASTELLOY B, C, G, N, and W are available, which contain different amount of ingredients such as molybdenum, chromium, iron, and cobalt. Any of the HASTELLOYs can be used for the substrate 3. Alternatively, for the substrate 3, an oriented Ni-W alloy tape substrate may be employed, the substrate being formed by introducing texture into a nickel alloy. The thickness of the substrate 3 may be adjusted in accordance with the purpose, typically be 10 to 500 $\mu$m, and preferably be 20 to 200 $\mu$m.

An example of the interlayer 4 may have a configuration in which a diffusion prevention layer, a bed layer, an orientation layer, and a cap layer are laminated in this order.

The diffusion prevention layer will serve to prevent part of the constituent elements of the substrate 3 from diffusing and being admixed, as impurities, into the oxide superconductor layer 5, when heat treatment is performed to the layers formed above the diffusion prevention layer and, as a result, imparts thermal hysteresis to the substrate 3 and the other layers. The specific structure of the diffusion prevention layer is not particularly limited provided it is capable of providing the above-described effects. It is preferable to employ a diffusion prevention layer having a single-layer or multilayer structure constituted by $Al_2O_3$, $Si_3N_4$, GZO ($Gd_2Zr_2O_7$), or the like, which are relatively effective in preventing the admixture of impurities.

The bed layer is used to prevent reactions of the constituent element at the interface between the substrate 3 and the oxide superconductor layer 5 and improve the orientation of layers which are provided on the bed layer. The specific structure of the bed layer is not particularly limited provided it is capable of providing the above-described effects. It is preferable to employ a bed layer having single-layer or multilayer structure constituted by a rare earth oxide which have high heat resistance, such as $Y_2O_3$, $CeO_2$, $La_2O_3$, $Dy_2O_3$, $Er_2O_3$, $Eu_2O_3$, and $Ho_2O_3$.

The orientation layer serves to control the crystal orientation of the cap layer and the oxide superconductor layer 5 which are formed thereon, prevent the constituent elements of the substrate 3 from diffusing into the oxide superconductor layer 5, and mitigate the difference between the substrate 3 and the oxide superconductor layer 5 in terms of physical characteristics such as coefficient of thermal expansion and lattice constant. The material of the orientation layer is not particularly limited provided it is capable of providing the above-described effects, but is preferably a metal oxide such as $Gd_2Zr_2O_7$, MgO, $ZrO_2$-$Y_2O_3$ (YSZ), and the like. When using such a metal oxide as the material of the orientation layer, a layer having high crystal orientation can be obtained with an ion beam assisted deposition method (hereinafter, may be referred to as IBAD method) which is described later, which will further improve the crystal orientation of the cap layer and the oxide superconductor layer 5.

The cap layer serves to strongly control the crystal orientation of the oxide superconductor layer 5 equally or more than the orientation layer, prevent the constituent elements of the oxide superconductor layer 5 from diffusing into the interlayer 4, and prevent reactions between the interlayer 4 and gases used in the process of laminating the oxide superconductor layer 5.

The material of the cap layer is not particularly limited provided it is capable of providing above-described effects, but is preferably a metal oxide such as $CeO_2$, $LaMnO_3$, $Y_2O_3$, $Al_2O_3$, $Gd_2O_3$, $ZrO_2$, $Ho_2O_3$, $Nd_2O_3$, and $Zr_2O_3$, in view of lattice matching with respect to the oxide superconductor layer 5. Of these materials, $CeO_2$ and $LaMnO_3$ are particularly preferable in view of the matching with respect to the oxide superconductor layer 5.

When using $CeO_2$ as the material of the cap layer, the cap layer may include a Ce-M-O based oxide in which part of Ce atoms are substituted with the other metal atoms or metal ions.

The oxide superconductor layer 5 serves to conduct an electric current when it is in a superconducting state. Wide variety of oxide superconductor materials having commonly-known compositions may be employed as the material of the oxide superconductor layer 5. Examples thereof include a copper oxide superconductor such as RE-123 based superconductor and Bi based superconductor. Examples of the composition of the RE-123 based superconductor include $REBa_2Cu_3O_{(7-x)}$ (RE represents a rare-earth element such as Y, La, Nd, Sm, Er, and Gd while x represents deficient oxygen), more particularly Y123 ($YBa_2Cu_3O_{(7-x)}$) and Gd123 ($GdBa_2Cu_3O_{(7-x)}$). Examples of the composition of the Bi based superconductor include $Bi_2Sr_2Ca_{n-1}Cu_n,O_{4+2n+\delta}$ (n represents the number of $CuO_2$ layers while $\delta$ represents excess oxygen). With respect to the copper oxide superconductor, introduction of oxygen through oxygen annealing into its original material, which is an insulator, will give an oxide superconductor having a well-organized crystal structure and exhibiting superconductive properties.

In the present example, a copper oxide superconductor is used as the material of the oxide superconductor layer 5, and unless otherwise stated, the material of the oxide superconductor layer 5 is a copper oxide superconductor hereinafter.

The protection layer 6 serves to bypass overcurrent (fault current) generated in case of emergency (e.g., short circuit by lightning strike etc.) together with a later-described stabilization layer 10, prevent chemical reactions between the oxide superconductor layer 5 and other layers provided thereon, and prevent the deterioration of the superconductive properties due to admixture of part of atoms of one of the laminated layers into another layer to cause perturbation of the composition of the layer. In addition, the protection layer 6 has oxygen permeability when heating, which allows oxygen to be easily introduced into the oxide superconductor layer 5.

In this regard, it is preferable that the protection layer 6 be formed of Ag or other materials including at least Ag, such as an Ag alloy.

It should be noted that the protection layer 6 is arranged only on the top face of the oxide superconductor layer 5 in FIG. 1 and FIG. 2, but the configuration is not limited to this. When forming the protection layer 6 with a film formation method such as a sputtering method, a thin Ag layer may be formed on at least one of the side faces of the substrate 3, the interlayer 4, the oxide superconductor layer 5, and the back face of the substrate 3 due to scattering around of Ag particles. Such a configuration may be employed.

The thickness D of the protection layer 6 formed on the oxide superconductor layer 5 may be 5 $\mu$m or less. When the thickness D of the protection layer 6 is 5 $\mu$m or less, it is possible to reduce the cost. In addition, the thickness D of the protection layer 6 is preferably 1 $\mu$m or more. If the thickness D of the protection layer 6 is less than 1 $\mu$m, Ag will be aggregated and the oxide superconductor layer 5 could be exposed from the protection layer 6 during the oxygen annealing of the protection layer 6. In the later-described stabilization layer 10 formed by covering the protection layer 6 with the metal tape 2 via the solder layer 7, part of Ag of the protection layer 6 will be absorbed by the solder. This means, the metal materials constituting the solder will diffuse into the protection layer 6 of Ag and the resistance value of the protection layer 6 of Ag will increase.

The oxide superconductor laminate 1 is configured as described above.

Next, the oxide superconductor wire A, in which the outer periphery of the above-described oxide superconductor laminate 1 is covered with the metal tape 2, will be described based on FIG. 1.

The metal tape 2 formed of an electrically conductive material such as a copper is arranged so as to cover the front face and both side faces of the protection layer 6, both side faces of the oxide superconductor layer 5 under the protection layer 6, both side faces of the interlayer 4, both side faces of the substrate 3, and part of the back face of the substrate 3 and thus the metal tape 2 forms the stabilization layer 10.

The stabilization layer 10 serves as a bypass to commutate electric current together with the protection layer 6 when the oxide superconductor layer 5 transitions from a superconducting state into a normal conducting state.

Both front and back face of the metal tape 2 is provided with the solder layer (low melting point metal layer) 7. The solder layer 7 includes an outer cover layer 7a covering the outer periphery of the metal tape 2, the inner cover layer 7b being tightly attached to the inner face of the metal tape 2 and covering the periphery of the oxide superconductor laminate 1, and the cover part 7c covering both ends, in the width direction, of the metal tape 2.

The metal tape 2 is bent to form, in view of the lateral cross section, substantially a C shape having a front-side wall 2a, a lateral-side wall 2b, and a back-side wall 2c, 2c, and extends from the front face of the protection layer 6 to the back face of the substrate 3 to cover the oxide superconductor laminate 1 so as to expose part of the back face of the substrate 3. In other words, the metal tape 2 covers the top face and both side faces of the protection layer 6, both side faces of the oxide superconductor layer 5, both side faces of the interlayer 4, both side faces of the substrate 3, and the back face of the substrate 3.

The inner cover layer 7b of the solder layer 7 is formed so as to completely fill the gap between the metal tape 2 and the oxide superconductor laminate 1 in the entire peripheral face of the oxide superconductor laminate 1.

The solder layer (low melting point metal layer) 7 of the present example is formed of solder, but the low melting point metal layer may be formed of a metal having a melting point within a range of 240 to 400°C such as Sn, Sn alloy, and indium. The above-described solder may be Sn-Pb based, Pb-Sn-Sb based, Sn-Pb-Bi based, Bi-Sn based, Sn-Cu based, Sn-Pb-Cu based, Sn-Ag based solder etc.. It should be noted that, since the solder layer 7 with high melting point will adversely affect the superconductive properties of the oxide superconductor layer 5 when melting the solder layer 7, it is preferable that the melting point of the solder layer 7 be lower. Specifically, it is preferable to use a material having a melting point of 350°C or less, more preferably within a range of approximately 240 to 300°C.

It is preferable that the thickness of the solder layer 7 be within a range of 1 $\mu$m to 10 $\mu$m, more preferably within a range of 2 $\mu$m to 6 $\mu$m. If the thickness of the solder layer 7 is less than 1 $\mu$m, the gap between the oxide superconductor laminate 1 and the metal tape 2 may not be completely filled, which will leave the gap. In addition, an alloy layer may be formed between the solder layer 7 and the metal tape 2 or between the solder layer 7 and the protection layer 6 of Ag due to the diffusion of the constituent elements of the solder layer 7 during the melting of the solder. On the other hand, if the thickness of the solder layer 7 is more than 10 $\mu$m, a large amount of the solder will be overflowed from the distal end of the back-side wall 2c of the metal tape 2 when performing soldering by heating and pressing the solder, with rolls as described later, to melt the solder. As a result, the thickness of the cover part 7c will become larger, which will cause irregular winding when winding the oxide superconductor wire A.

In the oxide superconductor wire A shown in FIG. 1, since the solder layer 7 filling the gap between the oxide superconductor laminate 1 and its peripheral metal tape 2 covers the periphery of the oxide superconductor laminate 1, it is possible to prevent outside moisture from permeating into the oxide superconductor laminate 1 arranged inside the metal tape 2.

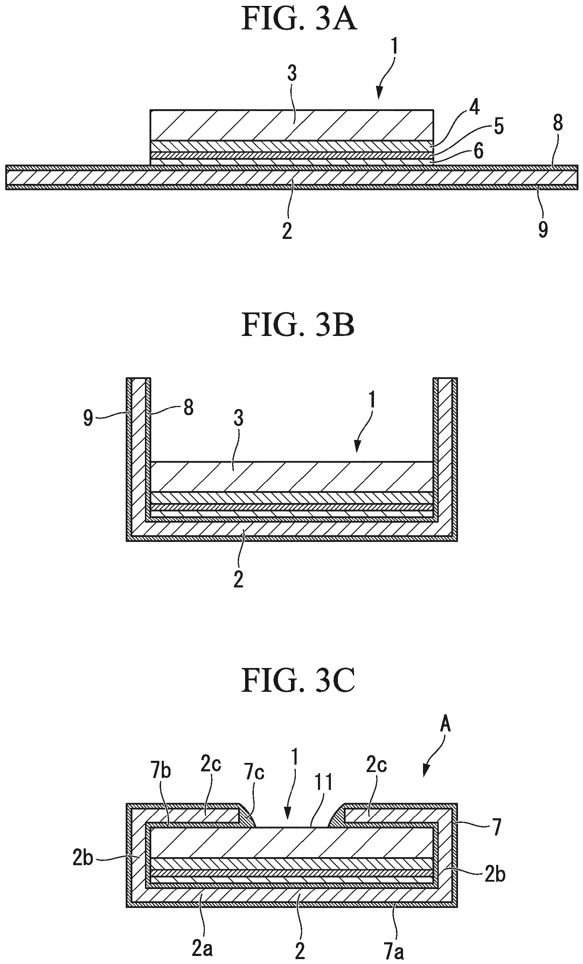

In manufacturing the oxide superconductor wire A shown in FIG. 1, the tape-shaped oxide superconductor laminate 1 is prepared to which the substrate 3, the interlayer 4, the oxide superconductor layer 5, and the protection layer 6 are laminated, and then the metal tape 2 is arranged under the protection layer 6 of the oxide superconductor laminate 1 as shown in FIG. 3A. Solder layers 8 and 9 are formed on the front and the back face of the metal tape 2 by plating. The thickness of the solder layers 8 and 9 is preferably within a range of 1 $\mu$m to 10 $\mu$m, more preferably within a range of 2 $\mu$m to 6 $\mu$m.

After aligning the positions of the center of the oxide superconductor laminate 1 and the center of the metal tape 2, both ends of the metal tape 2 are folded upwardly using a forming roll or the like so as to follow both side faces of the substrate 3 as shown in FIG. 3B. Then, the metal tape 2 is further folded so as to follow the top face of the substrate 3 as shown in FIG. 3C. As described above, the metal tape 2 is folded so as to form substantially a C shape in view of the lateral cross section.

After the folding described above, the whole is heated using a furnace up to the temperature at which the solder layers 8 and 9 are melted. Then, using a pressure roll heated up to a temperature around the melting point of the solder layers 8 and 9, the C shaped metal tape 2 and the oxide superconductor laminate 1 are pressed.

Through this process, the melted solder layers 8 and 9 spread so as to completely fill the gap between the oxide superconductor laminate 1 and the metal tape 2 and does fill the gap. After that, the whole is cooled to solidify the solder, and the oxide superconductor wire A as shown in FIG. 3C provided with the solder layer 7 is obtained, which has a structure equal to that shown in FIG. 1.

(Modified Examples)

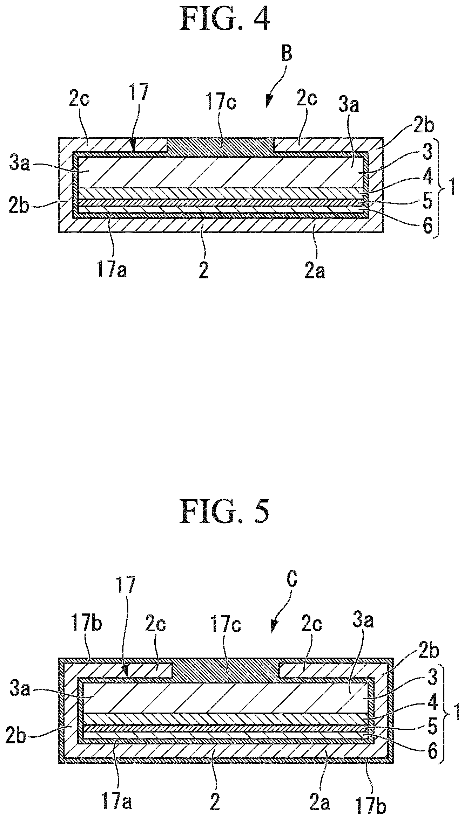

FIG. 4 and FIG. 5 are a lateral cross-sectional view of the oxide superconductor wires B and C which are a modified example of the oxide superconductor wire A according to the above-described example. In the oxide superconductor wire B according to the modified example, the tape-shaped oxide superconductor laminate 1 is covered with the metal tape 2 in the same way as the oxide superconductor wire A according to the above-described example.

The oxide superconductor wires B and C according to the present modified examples are different from the oxide superconductor wire A according to the above-described example in that a buried layer 17c formed of a solder layer (low melting point metal layer) 17 fills a gap 11 between the distal edges of the back-side walls 2c and 2c of the C shaped metal tape 2. In addition, an inner cover layer 17a of the solder layer (low melting point metal layer) 17 is formed only on the inner peripheral face of the metal tape 2 in the oxide superconductor wire B.

The oxide superconductor wires B and C shown in FIG. 4 and FIG. 5 have the same configuration as the oxide superconductor wire A except for the above-described configuration, and the same reference numerals are given to the correspondent components and explanations of those will be omitted.

In the oxide superconductor wires B and C shown in FIG. 4 and FIG. 5, the inner cover layer 17a fills the gap between the oxide superconductor laminate 1 and the metal tape 2 and the buried layer 17c fills the gap between the back-side walls 2c and 2c of the metal tape 2. The buried layer 17c prevents moisture from permeating into the oxide superconductor laminate 1, and particularly prevents moisture from permeating into the oxide superconductor layer 5 inside the metal tape 2. Even a configuration with the buried layer 17c in which a solder layer is not provided outside the metal tape 2 but the solder layer 17 is provided on the inner face of the metal tape 2 unlike the oxide superconductor wire B will prevent moisture from permeating into the inside.

Using a pressure roll and the other apparatus for supplying solder to the pressure roll, sufficient amount of solder to fill the gap between the back-side walls 2c and 2c of the metal tape 2 is supplied to form the buried layer 17c and thereby the oxide superconductor wires B and C can be obtained. Alternatively, it may be arranged to form a thick solder layer on the metal tape 2 in advance, heat the solder layer to melt it, and then cause an overflow of the melted solder from the gap between the back-side walls 2c and 2c the of metal tape 2, using a pressure roll, to form the buried layer 17c.

(Electrical properties in normal conducting state)

Hereinafter, the electrical properties of the above-described oxide superconductor wire A (B, C) according to the present invention will be described.

When the oxide superconductor wire A is applied to a superconductor current-limiting device, it is preferable that the resistance value R of the oxide superconductor wire A in a normal conducting state be within the range shown in the following Equation (1).

[Equation 1]

$$\frac{V}{\alpha Ic} > R \quad \dots (1)$$

In the Equation (1), V represents a voltage while Ic represents the critical current value of the oxide superconductor wire A. $\alpha$ is a coefficient multiplied to the critical current value Ic. Sufficient transition of the oxide superconductor layer 5 to a normal conducting state requires electric current 1.5 to 3 times the critical current value Ic. In other words, when the oxide superconductor layer 5 transitions from a superconducting state to a normal conducting state, electric current 1.5 to 3 times the critical current value Ic is applied to the stabilization layer 10 and the protection layer 6. Therefore, the coefficient $\alpha$ of 1.5 to 3 is multiplied to the critical current value Ic.

The critical current value Ic of the oxide superconductor layer 5 may be determined depending on the area of the cross section. Practically, for the oxide superconductor wire A having a width of 1 cm, the critical current value Ic is expected to be within a range of 50 to 1000 A.

It should be noted that, in order to achieve current limiting characteristics, it is required that the voltage drop of the oxide superconductor wire A having a width of 1cm and a length of 1 cm in a normal conducting state be within a range of 0.3 to 5 V.

By substituting values of the critical current value Ic, the voltage V, and the coefficient $\alpha$ in the above-described range into the Equation (1), a desirable range of the resistance value R of the oxide superconductor wire A in a normal conducting state can be calculated. Specifically, by substituting 0.3 V for the voltage V, 1000 A for the critical current value Ic, and 3 for the coefficient $\alpha$ into Equation (1), the lower limit of the resistance value: 100 $\mu\Omega$ can be obtained. On the other hand, by substituting 5 V for the voltage V, 50 A for the critical current value Ic, and 1.5 for the coefficient $\alpha$ into the Equation (1), the upper limit of the resistance value: 66.667 m$\Omega$ can be obtained.

The oxide superconductor wire A in use is cooled to be around 90 K by liquid nitrogen. The resistance value R described above means a resistance value at the temperature in use. Since the resistance value of a normal conductor of a copper alloy (brass, as an example) at room temperature (20°C) is around 1.5 times the resistance value at 90 K, the desirable range of the resistance value of the oxide superconductor wire A at room temperature is no less than 150 $\mu\Omega$ and no more than 100 m$\Omega$. It should be noted that, since the resistance value of the oxide superconductor wire is inversely proportional to its width, the desirable range of the resistance value described above is determined in accordance with the width of the oxide superconductor wire. For example, the desirable range of the resistance value of the oxide superconductor wire having a width of 5 mm and a length of 1 cm at room temperature is no less than 300 $\mu\Omega$ and no more than 200 m$\Omega$.

The resistance value of the oxide superconductor wire A in a normal conducting state is approximate to the resistance value of the oxide superconductor layer 5 in an insulating state and thus will be the combined resistance of the protection layer 6, the solder layer (low melting point metal layer) 7, 17, and the stabilization layer 10. Of these, the resistance value of the solder layer 7, 17 is substantially higher than the resistance value of the protection layer 6 and the stabilization layer 10 with consideration of the thickness (i.e., cross section area) and the volume resistivity of the solder layer. More specifically, since electric current hardly flows in the solder layer 7, 17, the contribution of the solder layer 7, 17 is negligible when calculating the resistance value. Therefore, the resistance value of the oxide superconductor wire A in a normal conducting state can be approximated by the combined resistance of the protection layer 6 and the stabilization layer 10.

The protection layer 6 is made of Ag or an Ag alloy. With the use of the protection layer 6 having a thickness D of 5 $\mu$m or less, it is possible to reduce the cost. In addition, it is preferable that the thickness D of protection layer 6 be 1 $\mu$m or more.

The resistance value of the stabilization layer 10 may be adjusted in various ways with parameters of the thickness d of the stabilization layer 10 and the volume resistivity of the constituent materials of the stabilization layer 10. Therefore, the thickness d of the stabilization layer 10 and the materials constituting the stabilization layer 10 may be selected such that the resistance value at room temperature of the oxide superconductor wire A, which includes the protection layer 6 having a thickness of no less than 1 $\mu$m and no more than 5 $\mu$m, will be in the range described above.

When using a material having a low volume resistivity as the material of the stabilization layer 10, the stabilization layer 10 needs to be thin. However, when forming the metal tape 2 as the stabilization layer 10 on the oxide superconductor laminate 1, tears can occur in the metal tape 2 if the thickness d of the metal tape 2 is too thin. Further, when folding the metal tape 2 in a C shape as described above and form it so as to cover the oxide superconductor laminate 1, tears can occur more easily.

On the other hand, when using a material having a high volume resistivity as the material of the stabilization layer 10, the stabilization layer 10 needs to be thick. However, if the stabilization layer 10 is thick, the thickness of the oxide superconductor wire A itself will become enlarged accordingly. Further, when folding the metal tape 2 in a C shape as described above and form it so as to cover the oxide superconductor laminate 1, it is extremely difficult to process the metal tape 2 having a thickness of more than 60 $\mu$m, which requires to apply a high stress to the metal tape 2 during the process and thereby may deteriorate the oxide superconductor layer 5.

In view of the above, it is preferable that the thickness d of the stabilization layer 10 be no less than 9 $\mu$m and no more than 60 $\mu$m. In this range of the thickness d, the volume resistivity of the stabilization layer 10 will be no less than 3.8 $\mu\Omega\cdot$cm and no more than 15 $\mu\Omega\cdot$cm in order for the resistance value of the oxide superconductor wire A to be no less than 150 $\mu\Omega$ and no more than 100 m$\Omega$. The volume resistivity of no less than 3.8 $\mu\Omega\cdot$cm and no more than 9.6 $\mu\Omega\cdot$cm is more preferable.

Examples of the material of the stabilization layer 10 (i.e., metal tape 2) satisfying such a volume resistivity include copper nickel alloy (GCN15, GCN10, GCN5: corresponding standard JIS C 2532), Corson alloy, brass (Cu-Zn alloy), beryllium copper, and phosphor bronze.

Table 1 shows the relationship between the thickness of the protection layer 6 and the thickness of the stabilization layer 10, and the resistance value of the oxide superconductor wire at room temperature (normal conducting state), when using a Corson alloy (C7025) having a volume resistivity of 3.8 $\mu\Omega\cdot$cm as the material of the stabilization layer 10.

On the other hand, Table 2 shows the relationship between the thickness of the protection layer 6 and the thickness of the stabilization layer 10, and the resistance value of the oxide superconductor wire at room temperature (normal conducting state), when using a copper nickel alloy (GCN15) having a volume resistivity of 15 $\mu\Omega\cdot$cm as the material of the stabilization layer 10.

[Table 1]

| Protection layer | Stabilization layer | Oxide superconductor wire |
|---|---|---|
| Ag | C7025 Corson alloy (volume resistivity of 3.8 $\mu\Omega\cdot$cm) | Resistance value (room temperature, 1cm width, 1 cm long) |
| Layer thickness | Thickness | |
| 1 $\mu$m | 12.0 $\mu$m | 1.26 m$\Omega$ |
| 3 $\mu$m | 11.5 $\mu$m | 1.14 m$\Omega$ |
| 5 $\mu$m | 9.4 $\mu$m | 1.14 m$\Omega$ |

[Table 2]

| Protection layer | Stabilization layer | Oxide superconductor wire |
|---|---|---|
| Ag | GCN15 Copper nickel alloy (volume resistivity of 15 $\mu\Omega\cdot$cm) | Resistance value (room temperature, 1cm width, 1 cm long) |
| Layer thickness | Thickness | |
| 1 $\mu$m | 55.0 $\mu$m | 1.12 m$\Omega$ |
| 3 $\mu$m | 45.0 $\mu$m | 1.31 m$\Omega$ |
| 5 $\mu$m | 35.0 $\mu$m | 1.17 m$\Omega$ |

As will be appreciated from Table 1, when the volume resistivity of the stabilization layer 10 is 3.8 $\mu\Omega\cdot$cm, it is possible to achieve a desirable combined resistance value (i.e., the resistance value of the oxide superconductor wire at room temperature) by adjusting the thickness of the stabilization layer 10 to be in a range of 9.4 to 12.0 $\mu$m to correspond with the protection layer 6 having a thickness of 1 to 5 $\mu$m. Similarly, as will be appreciated from Table 2, when the volume resistivity of the stabilization layer 10 is 15 $\mu\Omega\cdot$cm, it is possible to achieve a preferable combined resistance value by adjusting the thickness of the stabilization layer 10 to be in a range of 35.0 to 55.0 $\mu$m.

In view of the above, when the volume resistivity of the stabilization layer 10 is within 3.8 to 15 $\mu\Omega\cdot$cm, it is possible to obtain an oxide superconductor wire having a preferable resistance value at room temperature by adjusting the thickness of the stabilization layer 10 to be in a range of 9.4 to 58 $\mu$m to correspond with the protection layer 6 having a thickness of 1 to 5 $\mu$m.

(Superconductor current-limiting device)

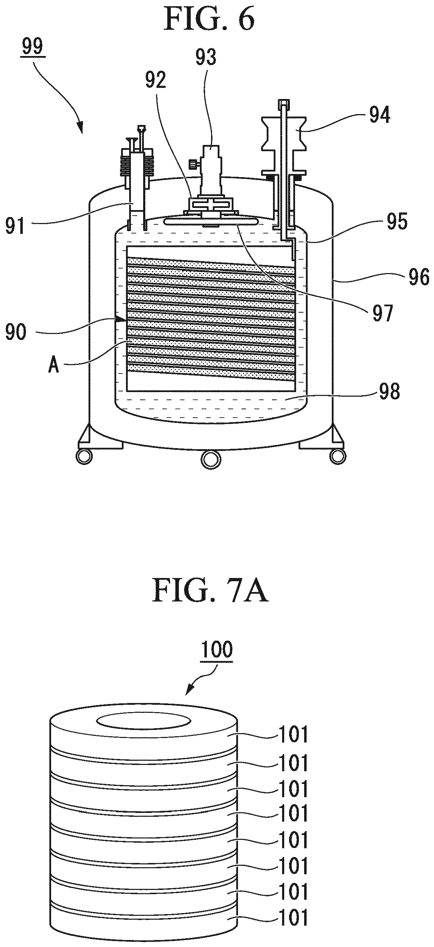

FIG. 6 shows a superconductor current-limiting device 99 using the oxide superconductor wire A (or B, C) described above.

In the superconductor current-limiting device 99, the oxide superconductor wire A (B, C) is wound in plural layers around a drum to constitute a module 90 for a superconductor current-limiting device. The module 90 for a superconductor current-limiting device is housed in a liquid nitrogen tank 95 which is filled with liquid nitrogen 98. The liquid nitrogen tank 95 is housed inside a vacuum tank 96 which keeps out heat from outside.

A liquid nitrogen supply part 91 and a refrigerator 93 are provided on top of the liquid nitrogen tank 95. A heat anchor 92 and a heat plate 97 are provided under the refrigerator 93.

In addition, the superconductor current-limiting device 99 includes a current lead part 94 for connecting the module 90 for a superconductor current-limiting device with an external power source (not shown in the figures).

(Superconductor coil)

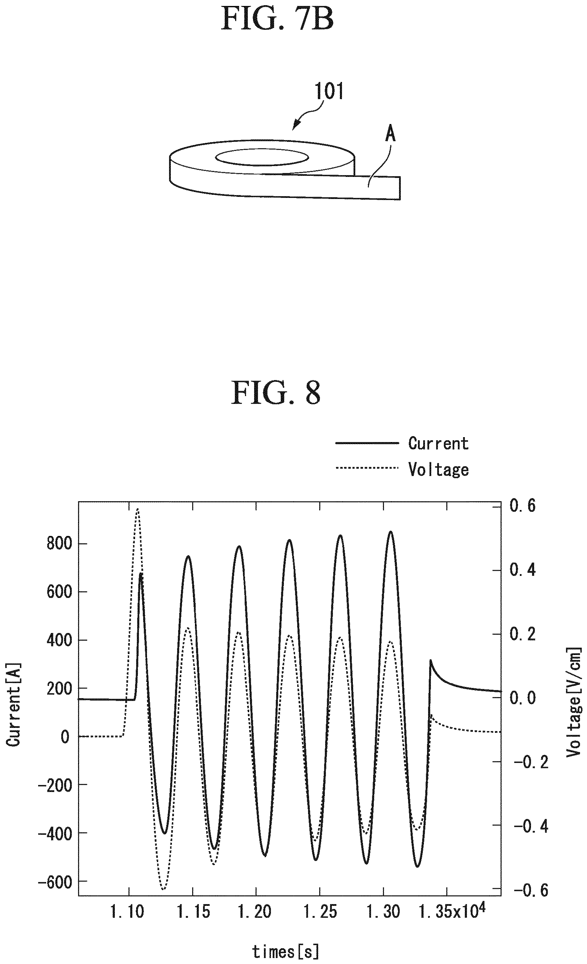

FIG. 7B shows a pancake coil 101 using the oxide superconductor wire A (B, C) as described above. The oxide superconductor wire A may form a wound pancake coil 101. Further, by stacking plural pancake coils 101 and connecting them with one another, it may form a superconductor coil 100 shown in FIG. 7A which will generate strong magnetic force.

As is explained above, the oxide superconductor wires A, B, and C may be used for various superconductor equipment. It should be noted that the superconductor equipment is not particularly limited provided it includes the oxide superconductor wire A, and examples thereof include a superconductor cable, a superconductor motor, a superconductor transformer, a superconductor current-limiting device, and a superconductor electricity storage.

[Example]

Hereinafter, examples of the present invention will be described in detail with the use of examples, but the present invention is not limited to the examples.

(Sample preparation)

An $Al_2O_3$ layer (diffusion prevention layer; thickness of 150 nm) was formed on a substrate made of tape-shaped HASTELLOY (Trade name, HAYNES INT. INC., USA) having a width of 5 mm and thickness of 0.1 mm by a sputtering method, and a $Y_2O_3$ layer (bed layer; thickness of 20 nm) was formed on the diffusion prevention layer by an ion beam sputtering method. Then, an MgO layer (metal oxide layer; thickness of 10 nm) was formed on the bed layer by an ion beam assisted deposition method (IBAD method) and a $CeO_2$ (cap layer) having a thickness of 0.5 $\mu$m was formed on the metal oxide layer by a pulse laser deposition method (PLD method). After that, a $GdBa_2Cu_3O_{7-\delta}$ (oxide superconductor layer) having a thickness of 2.0 $\mu$m was formed on the cap layer by PLD method and an Ag layer (protection layer) having a thickness of 5 $\mu$m was formed on the oxide superconductor layer by a sputtering method. In addition, a Sn-solder plated metal tape having a width of 10 mm was folded at both sides of the protection layer to form substantially a C shape in view of the lateral cross section, and the periphery of the oxide superconductor laminate was covered with the metal tape. After that, the Sn solder was melted by heating to form a solder layer such that the metal tape covered and was adhered to the periphery of the oxide superconductor laminate. Metal tapes having a thickness and made of a material shown in Table 3 were used. Through the process described above, oxide superconductor wires of Examples 1 to 6 and Comparative examples 1 and 2 were obtained.

The oxide superconductor wires of Examples 1 to 6 and Comparative examples 1 and 2 were subjected to the pressure cooker test in which they were exposed to high temperature (120°C), high humidity (100%), and high pressure (0.2 MPa) for 100 hours, and the ratio of the critical current value before and after the test were measured. For each oxide superconductor wire, the percent ratio of the post-exposure critical current value (Ic) to the pre-exposure critical current value ($Ic_0$), which represents moisture derived deterioration, is shown in Table 3.

In addition, as to the current limiting characteristics, the suppression performance of excessive current in case of emergency was confirmed as follows. Each of the oxide superconductor wires of Examples 1 to 6 and Comparative examples 1 and 2 was cut into 10 cm long, and excessive current equivalent to the expected extraordinary current was applied between both ends of the wire. The waveform of the electric current from immediately after the application of the electric current to the sixth wave was observed to confirm whether or not the current limiting effect was obtained for each wire. The results are shown in Table 3. It should be noted that "O" in the table represents that the metal tape was able to be formed while "X" represents that the metal tape was unable to be formed. In addition, an exemplary example of the waveform of the electric current is shown in FIG. 8, which was measured when excessive current equivalent to the expected fault current was applied to the oxide superconductor wire of Example 2.

[Table 3]

| | | Metal tape | Volume resistivity ($\mu\Omega\cdot$cm) | Foil thickness ($\mu$m) | Formability | Moisture derived deterioration Ic/Ic$_0$ | Current limiting characteristics |
|---|---|---|---|---|---|---|---|
| Comparative example 1 | C1020R | Oxygen free copper | 1.7 | 5 | X | 100% | O |
| Example 1 | C7025 | Corson alloy | 3.8 | 10 | O | 0% | O |
| Example 2 | GCN5 | Cupronickel | 5.0 | 15 | O | 0% | O |
| Example 3 | C2680R | Brass | 6.4 | 20 | O | 0% | O |
| Example 4 | C1720R | Beryllium alloy | 9.6 | 30 | O | 0% | O |
| Example 5 | C5191R | Phosphor bronze | 13 | 40 | O | 0% | O |
| Example 6 | GCN15 | Cupronickel | 15 | 50 | O | 0% | O |
| Comparative example 2 | C7521R | Nickel silver | 29 | 96 | X | *30% | *O |

As shown in Table 3, the metal tape was unable to be formed so as to cover the oxide superconductor laminate in the oxide superconductor wire of Comparative examples 1 and 2. More specifically, as for Comparative example 1, since the thickness 5 μm of the foil of oxygen free copper used as the metal tape was thin, the metal tape wan torn while forming the metal tape in a C shape and thus the oxide superconductor laminate was unable to be covered.

On the other hand, as for Comparative example 2, since the nickel silver used as the metal tape has high rigidity and the foil thickness 96 μm was thick, the metal tape made of a nickel silver was unable to be formed in a C shape.

Accordingly, as for the moisture derived deterioration and the current limiting characteristics of Comparative examples 1 and 2, evaluations were performed for wires in which the metal tape which has a thickness of twice the foil thickness described in Table 3 was formed on the protection layer of the oxide superconductor laminate via the solder layer form.

The oxide superconductor wires of Comparative examples 1 and 2 were unable to air-tightly cover the oxide superconductor laminate and were thus deteriorated in the pressure cooker test.

In contrast, the oxide superconductor wires of Examples 1 to 6 were not deteriorated in the pressure cooker test.

It should be noted that all the oxide superconductor wires of Examples 1 to 6 and Comparative examples 1 and 2 exhibited excellent current limiting characteristics. With reference to the exemplary example of the waveform of the electric current measured for the wire of Example 2 shown in FIG. 8, it is observed that the current value is gradually reduced from the first wave.

As described above, it was confirmed that the oxide superconductor wires according to the examples of the present invention exhibited excellent current limiting characteristics. Moreover, in the oxide superconductor wires according to the examples of the present invention, it was confirmed that no moisture derived deterioration occurred even under extreme environmental conditions since the periphery of the oxide superconductor laminate was covered with the metal tape having a certain thickness.

INDUSTRIAL APPLICABILITY

According to the examples of the present invention, it is possible to provide an oxide superconductor wire for use in superconductor current-limiting devices, which is, even if the thickness of the protection layer is reduced, capable of preventing burnout, exhibiting stable current limiting characteristics, and limiting the enlargement of the thickness of the oxide superconductor wire.

DESCRIPTION OF THE REFERENCE SYMBOLS

| | |
|---|---|
| 1 | Oxide superconductor laminate |
| 2 | Metal tape |
| 3 | Substrate |
| 4 | Interlayer |
| 5 | Oxide superconductor layer |
| 6 | Protection layer |
| 7, 17 | Solder layer (low melting point metal layer) |
| 10 | Stabilization layer |
| 99 | Superconductor current-limiting device |
| A, B, C | Oxide superconductor wire |
| D | Thickness (protection layer) |
| d | Thickness (stabilization layer) |

Claims

1.  An oxide superconductor wire (A) comprising:

an oxide superconductor laminate (1) comprising: a tape-shaped substrate (3), an interlayer (4) laminated on the substrate (3), an oxide superconductor layer (5) laminated on the interlayer (4), and a protection layer (6) which is formed of Ag or an Ag alloy and laminated on the oxide superconductor layer (5); and
a stabilization layer (10) which is formed of a metal tape (2) and formed on the protection layer (6) of the superconductor laminate (1) via a low melting point metal or solder layer (7),
wherein the thickness of the protection layer (6) is 5 μm or less,

wherein the thickness of the stabilization layer (10) is no less than 9 $\mu$m and no more than 60 $\mu$m, wherein a width of the metal tape (2) constituting the stabilization layer (10) is greater than the width of the oxide superconductor laminate (1), wherein a top face of the protection layer (6) of the oxide superconductor laminate (1), and side faces of the protection layer (6), the oxide superconductor layer (5), the interlayer (4) and the substrate (3) are covered with the stabilization layer (10) via the low melting point metal layer (7), wherein the metal tape (2) constituting the stabilization layer (10) has a back-side wall (2c) at both ends thereof, wherein both back-side walls (2c) follow and are disposed on a back face of the substrate (3) and cover part of the back face of the substrate (3) via the low melting point metal layer (7), and **characterized in that** the solder layer (7) includes a cover part (7c) covering both ends, in the width direction, of the metal tape (2) and wherein the volume resistivity of the stabilization layer (10) at room temperature is no less than 3.8 $\mu\Omega$ cm and no more that 15 $\mu\Omega$ cm.

2. The oxide superconductor wire (A) according to claim 1, wherein a resistance value of the oxide superconductor wire (A) per 1 cm width and 1 cm length at room temperature is no less than 150 $\mu\Omega$ and no more than 100 m$\Omega$.

3. The oxide superconductor wire (A) according to claim 1 or 2, wherein the protection layer (6) is formed on at least one of side faces of the substrate (3), the interlayer (4), the oxide superconductor layer (5), and the back face of the substrate (3).

4. A superconductor coil (100) comprising the oxide superconductor wire (A) according to any one of claims 1 to 3.

5. A superconductor current-limiting device (99) comprising the oxide superconductor wire (A) according to any one of claims 1 to 3.

6. A superconductor equipment comprising the oxide superconductor wire (A) according to any one of claims 1 to 3.

7. The oxide superconductor wire (A) according to claim 1 or 2, wherein, between the distal edges of the back-side walls (2c), the back face of the substrate (3) is exposed from the stabilization layer (10) and the low melting point metal layer (7).

8. The oxide superconductor wire (A) according to claim 1 or 2, the wire (A) further comprising a buried layer (17c) filling a gap between the distal edges of the back-side walls (2c) of the stabilization layer (10).

**Patentansprüche**

1. Oxidsupraleiterdraht (A), umfassend:

ein Oxidsupraleiterlaminat (1), umfassend: ein bandförmiges Substrat (3), eine auf das Substrat (3) laminierte Zwischenschicht (4), eine auf die Zwischenschicht (4) laminierte Oxidsupraleiterschicht (5) und eine Schutzschicht (6), die aus Ag oder einer Ag-Legierung besteht und auf die Oxidsupraleiterschicht (5) laminiert ist; und eine Stabilisierungsschicht (10), die aus einem Metallband (2) besteht und mithilfe einer Schicht aus Metall mit niedrigem Schmelzpunkt oder Lötmittel (7) auf der Schutzschicht (6) des Supraleiterlaminats (1) gebildet ist, wobei die Dicke der Schutzschicht (6) 5 $\mu$m oder weniger beträgt, wobei die Dicke der Stabilisierungsschicht (10) nicht weniger als 9 $\mu$m und nicht mehr als 60 $\mu$m beträgt, wobei eine Breite des Metallbands (2), das die Stabilisierungsschicht (10) bildet, größer als die Breite des Oxidsupraleiterlaminats (1) ist, wobei eine obere Seite der Schutzschicht (6) des Oxidsupraleiterlaminats (1) und Seitenflächen der Schutzschicht (6), der Oxidsupraleiterschicht (5), der Zwischenschicht (4) und des Substrats (3) mithilfe der Schicht aus Metall mit niedrigem Schmelzpunkt (7) mit der Stabilisierungsschicht (10) bedeckt sind, wobei das Metallband (2), das die Stabilisierungsschicht (10) bildet, an beiden Enden davon eine rückseitige Wand (2c) aufweist, wobei beide rückseitige Wände (2c) der Rückseite des Substrats (3) folgen und daran angeordnet sind und mithilfe der Schicht aus Metall mit niedrigem Schmelzpunkt (7) einen Teil der Rückseite des Substrats (3) bedecken und **dadurch gekennzeichnet, dass** die Lötmittelschicht (7) einen Abdeckteil (7c) umfasst, der beide Enden des Metallbands (2) in der Breitenrichtung bedeckt, und wobei der spezifische Volumenwiderstandswert der Stabilisierungsschicht (10) bei Raumtemperatur nicht weniger als 3,8 μΩ cm und nicht mehr als 15 μΩ cm beträgt.

**2.** Oxidsupraleiterdraht (A) gemäß Anspruch 1, wobei ein Widerstandswert des Oxidsupraleiterdrahts (A) pro 1 cm Breite und 1 cm Länge bei Raumtemperatur nicht weniger als 150 μΩ und nicht mehr als 100 μΩ beträgt.

**3.** Oxidsupraleiterdraht (A) gemäß Anspruch 1 oder 2,
wobei die Schutzschicht (6) auf wenigstens einer der Seitenflächen des Substrats (3), der Zwischenschicht (4), der Oxidsupraleiterschicht (5) und der Rückseite des Substrats (3) gebildet ist.

**4.** Supraleiterspule (100), umfassend den Oxidsupraleiterdraht (A) gemäß einem der Ansprüche 1 bis 3.

**5.** Supraleiter-Strombegrenzungsvorrichtung (99), umfassend den Oxidsupraleiterdraht (A) gemäß einem der Ansprüche 1 bis 3.

**6.** Supraleitervorrichtung, umfassend den Oxidsupraleiterdraht (A) gemäß einem der Ansprüche 1 bis 3.

**7.** Oxidsupraleiterdraht (A) gemäß Anspruch 1 oder 2, wobei zwischen den distalen Rändern der rückseitigen Wände (2c) die Rückseite des Substrats (3) von der Stabilisierungsschicht (10) und der Schicht aus Metall mit niedrigem Schmelzpunkt (7) freiliegt.

**8.** Oxidsupraleiterdraht (A) gemäß Anspruch 1 oder 2, wobei der Draht (A) ferner eine vergrabene Schicht (17c) umfasst, die eine Lücke zwischen den distalen Rändern der rückseitigen Wände (2c) der Stabilisierungsschicht (10) füllt.

## Revendications

**1.** Fil supraconducteur en oxyde (A) comprenant :

un stratifié supraconducteur en oxyde (1) comprenant : un substrat en forme de bande (3), une couche intermédiaire (4) stratifiée sur le substrat (3), une couche supraconductrice en oxyde (5) stratifiée sur la couche intermédiaire (4), et une couche protectrice (6) formée d'Ag (argent) ou d'un alliage d'Ag et stratifiée sur la couche supraconductrice en oxyde (5) ; et
une couche de stabilisation (10) formée d'une bande métallique (2) et formée sur la couche protectrice (6) du stratifié supraconducteur (1) par l'intermédiaire d'une couche de soudure ou de métal à bas point de fusion (7),
dans lequel l'épaisseur de la couche protectrice (6) est d'au moins 5 μm,
dans lequel l'épaisseur de la couche de stabilisation (10) est d'au moins 9 μm et n'excède pas 60 μm,
dans lequel la largeur de la bande métallique (2) constituant la couche de stabilisation (10) est supérieure à la largeur du stratifié supraconducteur en oxyde (1),
dans lequel la face supérieure de la couche protectrice (6) du stratifié supraconducteur en oxyde (1) et les faces latérales de la couche protectrice (6), la couche supraconductrice en oxyde (5), la couche intermédiaire (4) et le substrat (3) sont recouverts par la couche de stabilisation (10) par l'intermédiaire de la couche en métal à bas point de fusion (7),
dans lequel la bande métallique (2) constituant la couche de stabilisation (10) possède une paroi arrière (2c) à ses deux extrémités,
dans lequel les deux parois arrières (2c) s'étendent le long et au-dessus de la face arrière du substrat (3) et recouvrent une partie de la face arrière du substrat (3) par l'intermédiaire de la couche en métal à bas point de fusion (7), et
**caractérisé en ce que** la couche de soudure (7) comporte une partie de recouvrement (7c) recouvrant dans la largeur les deux extrémités de la bande métallique (2) et dans lequel la résistivité volumique de la couche stabilisation (10) à température ambiante est d'au moins 3,8 μΩ cm et n'excède pas 15 μΩ cm.

**2.** Fil supraconducteur en oxyde (A) selon la revendication 1, dans lequel la valeur de résistance du fil supraconducteur en oxyde (A) pour 1 cm en largeur et 1 cm en longueur à température ambiante est d'au moins 150 μΩ et n'excède pas 100 mΩ.

**3.** Fil supraconducteur en oxyde (A) selon la revendication 1 ou 2,
dans lequel la couche protectrice (6) est formée sur au moins une des faces latérales du substrat (3), de la couche intermédiaire (4), de la couche supraconductrice en oxyde (5), et de la face arrière du substrat (3).

4. Bobine supraconductrice (100) comprenant le fil supraconducteur en oxyde (A) selon l'une quelconque des revendications 1 à 3.

5. Dispositif limiteur de courant supraconducteur (99) comprenant le fil supraconducteur en oxyde (A) selon l'une quelconque des revendications 1 à 3.

6. Équipement supraconducteur comprenant le fils supraconducteur en oxyde (1) selon l'une quelconque des revendications 1 à 3.

7. Fil supraconducteur en oxyde (A) selon la revendication 1 ou 2, dans lequel, entre les bords distaux des parois arrières (2c), la face arrière du substrat (3) est apparente depuis la couche de stabilisation (10) et la couche en métal à bas point de fusion (7).

8. Fil supraconducteur en oxyde (A) selon la revendication 1 ou 2, le fil (A) comprenant en outre une couche enterrée (17c) comblant l'espace entre les bords distaux des parois arrières (2c) de la couche stabilisation (10).

EP 2 940 699 B1

# FIG. 1

# FIG. 2

# FIG. 3A

# FIG. 3B

# FIG. 3C

# FIG. 4

# FIG. 5

# FIG. 6

# FIG. 7A

# FIG. 7B

# FIG. 8

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2012169237 A
- JP 2007227167 A
- US 2008194411 A
- US 2006073975 A
- JP 2012150914 A
- US 2009110906 A